# EUROPÄISCHE PATENTANMELDUNG

(11) **EP 0 901 086 A2**
(43) Veröffentlichungstag der Anmeldung: **10.03.1999**
(21) Anmeldenummer: 98115145.9
(22) Anmeldetag: 12.08.1998
(51) Int. Cl.: G06F 17/50

(54) **Verfahren zur Dimensionierung von Bauteilen**

(30) Priorität: 20.08.1997 DE 19736043
(71) Anmelder: ComCAD GmbH Analog Design Support, 25704 Meldorf (DE)
(72) Erfinder: Fischer-Binder, Jörg-Oliver, 25704 Meldorf (DE)
(74) Vertreter: Bergmeier, Werner, Dipl.-Ing.

(57) **Zusammenfassung**

Die Erfindung betrifft ein Verfahren zur Dimensionierung von Bauteilen in einer vorgegebenen Baugruppe, insbesondere einer elektronischen Schaltung, welche eine vorbestimmte, insbesondere in Randbedingungen festgelegte Funktionalität zu erfüllen hat. Die einzelnen Bauteile weisen Eigenschaften auf, die im wesentlichen vorbestimmt und in mathematischen Gleichungen beschrieben sind und die Bauteile auf Grund ihres Einsatzes in der vorgegebenen Baugruppe bzw. elektronischen Schaltung Wechselwirkungen erzeugen. Die durch die Gleichungen beschriebenen Eigenschaften und/oder Wechselwirkungen werden mittels eines Computers gelöst, wobei die erhaltenen Ergebnisse der ersten gelösten Gleichungen zu den erforderlichen Bauteilen bei der Lösung der weiteren Gleichungen herangezogen werden. Auf die Lösung und Weiterbearbeitung derjenigen Bereiche der Lösungsmöglichkeiten, die für die Dimensionierung der Bauteile in dieser vorgegebenen elektronischen Schaltung ohne praktische Relevanz sind, wird verzichtet.

## Beschreibung

Die Erfindung betrifft ein Verfahren zur Dimensionierung von Bauteilen in einer vorgegebenen Baugruppe, insbesondere einer elektronischen Schaltung, welche eine vorbestimmte, insbesondere in Randbedingungen festgelegte Funktionalität zu erfüllen hat, wobei die einzelnen Bauteile Eigenschaften aufweisen, die im wesentlichen vorbestimmt und in mathematischen Gleichungen beschrieben sind, und wobei die Bauteile auf Grund ihres Einsatzes in der vorgegebenen Baugruppe bzw. elektronischen Schaltung Wechselwirkungen erzeugen.

Es sind Verfahren bekannt, mit welchen auf verschiedenen technischen Gebieten bei gegebener Beschreibung der Randbedingungen einer technischen Ausführung und aus der ebenfalls bekannten Beschreibung von gewünschten Eigenschaften einer Baueinheit eine Dimensionierung von Bauteilen in Baugruppen erzeugt werden kann. Solche Verfahren finden insbesondere bei der Konstruktion elektronischer Schaltungen ihren Einsatz. Beispielhaft hierfür sind Verfahren und Vorrichtungen für die Dimensionierung der Bauteile digitaler Schaltsysteme, die beispielsweise durch die Firmen Synopsis Inc. oder Mentor Graphics Inc. auf dem Markt angeboten werden.

Ebenfalls sind seit längerem solche Verfahren bekannt, welche für spezielle Anwendungen von elektronischen Schaltungen auf dem Gebiet der analogen Schaltungstechnik eingesetzt werden. Beispielhaft hierfür seien Verfahren für die Dimensionierung von Switch-Capacitor-Schaltungen auf dem Gebiet der werte- und zeitkontinuierlichen Schaltungen, wie beispielsweise Operationsverstärker, genannt.

Die Verfahren des Standes der Technik arbeiten nach folgendem Grundprinzip: Zuerst wird ein mathematisches Gleichungssystem erstellt, das das zu dimensionierende physikalische System, z.B. die vorgegebene elektronische Schaltung, repräsentiert. Danach erfolgt die Zerlegung dieses Gleichungssystems in explizit lösbare Teilsysteme und verbleibende implizite Teilgleichungssyteme, die dann mit Hilfe numerischer, interaktiver Methoden bearbeitet werden. Der Erfolg dieser Methoden ist dabei extrem abhängig von den Randbedingungen und der Struktur des zu schaffenden physikalischen Systems. Die Startwerte zur Berechnung der impliziten Teilgleichungssyteme werden hierbei als Konstanten behandelt, die unabhängig von dem zu dimensionierenden physikalischen System ermittelt und in das Gleichungssystem eingesetzt werden.

Die Verfahren des Standes der Technik haben alle gemeinsam, daß sie ein mathematisch unvollständig definiertes Problem in ein mathematisch vollständig definiertes Problem überführen wollen und eine Lösung hierfür anstreben. Ein solches Verfahren liefert aber nicht immer eine technische Lösung, da es nicht immer gelingt das vorliegende Problem in ein vollständig definiertes Problem überzuführen. Es wird daher nicht immer eine brauchbare, vollständige technische Lösung erhalten.

Aufgabe der vorliegenden Erfindung ist es somit, ein Verfahren zu schaffen, mit welchem es ermöglicht wird, die erforderliche Dimension von Bauteilen auch in großen Baugruppen und damit mit großen Gleichungssystemen bestimmen zu können und dabei eine einsatzfähige technische Lösung für eine festgelegte Funktionalität zu erhalten.

Die Aufgabe wird gelöst durch einem Verfahren mit den Merkmalen des Anspruchs 1.

Werden die durch die Gleichungen beschriebenen Eigenschaften und/oder Wechselwirkungen mittels eines Computers gelöst, so werden in erfinderischer Weise die erhaltenen Ergebnisse der ersten gelösten Gleichungen zu den erforderlichen Bauteilen bei der Lösung der weiteren Gleichungen herangezogen. Besonders wesentlich ist es, daß auf die Lösung und Weiterbearbeitung derjenigen Lösungsmöglichkeiten, die für die Dimensionierung der Bauteile in dieser vorgegebenen Baugruppe bzw. elektronischen Schaltung ohne praktische Relevanz sind, verzichtet wird. Es wird damit ermöglicht, daß nicht das komplette Gleichungssystem gelöst werden muß, sondern lediglich die Teile des Gleichungssystems, welche in der konkreten vorgegebenen Baugruppe (Schaltung) für die Gestaltung der Bauteile, welche in dieser Baugruppe (Schaltung) eingesetzt werden sollen, berechnet werden. Die übrigen Gleichungen, welche zu Lösungen führen würden, welche nicht beim Einsatz in der vorgegebenen Baugruppe (Schaltung) erforderlich wären, werden nicht berechnet. Dadurch wird es ermöglicht, daß ein wesentlich einfacheres Gleichungssystem zu lösen ist, welches in wesentlich kürzerer Zeit und mit weniger leistungsstarken Computern bearbeitet werden kann. Darüber hinaus wird ein technisches System, nämlich beispielsweise eine Schaltung mit derart dimensionierten Bauteilen erhalten, welches sehr genau die geforderte Funktionalität aufweist. Es wird somit sowohl der Vorteil eines leichter berechenbaren Gleichungssystem zum Erhalten richtig dimensionierter Bauteile und außerdem eine Baugruppe mit genau der Funktionalität, welche festgelegt und gewünscht wurde, erhalten.

Besonders vorteilhaft ist es, wenn die Bereiche der Lösungsmöglichkeiten, die entsprechend der vorbestimmten Funktionalität der vorgegebenen Baugruppe, insbesondere der vorgegebenen elektronischen Schaltung, von Bedeutung sind, vorgegeben werden. Das erfinderische Verfahren wird damit zusätzlich vereinfacht, da das Gleichungssystem dahingehend eingeschränkt wird, daß lediglich die relevanten Gleichungen oder Lösungen einer Gleichung zu betrachten sind.

Stellt das System fest, daß widersprüchliche oder unbestimmte Lösungsmöglichkeiten sich aus dem Gleichungssystem ergeben und damit widersprüchliche oder unbestimmte Angaben für die Dimensionierung der Bauteile resultieren, können während der Berechnung des Gleichungssystem bzw. der Dimensionierung der Bauteile anhand der vorgegebenen Funktionalität der Baugruppe bzw. der elektronischen Schaltung, die Bereiche der Lösungsmöglichkeiten für Funktionalitäten ohne praktischer Relevanz in dieser Baugruppe ausgeschlossen werden. Auch hierdurch wird bewirkt, daß in vorteilhafter Weise lediglich die Lösungsmöglichkeiten weiterverfolgt werden, welche tatsächlich in der gewünschten Baugruppe Verwendung finden, ohne daß es dabei zu einer Überdimensionierung oder gar Unterdimensionierung der Bauteile kommen würde.

Bei widersprüchlichen oder unbestimmten Lösungsmöglichkeiten werden entweder Bereiche der Lösungsmöglichkeiten hinsichtlich ihrer Relevanz eingeschränkt oder verändert. Es können aber auch durch eine Änderung der Startwerte der Berechnung eindeutige und unwidersprüchliche Lösungen erhalten werden. Die Startwerte, welche als Konstanten innerhalb der Randbedingungen gewählt werden, erlauben anhand einer beispielhaften Wertebelegung innerhalb des gewünschten Wertebereiches eine Berechnung des Gleichungssystems. Je nach Wahl der Startwerte, kann das Gleichungssystem einfacher oder schwieriger zu lösen sein. Es kann deshalb vorteilhaft sein, die Startwerte zu ändern, wodurch ein vormals schwierig zu lösendes Gleichungssystem nun einfach und eindeutig zu lösen ist. Bei einer widersprüchlichen oder unbestimmten Lösung kann es beispielsweise in Abhängigkeit von den bereits zuvor durchgeführten Änderungen vorteilhaft sein, wenn eine Hierarchie in der Änderung der Bereiche, Startwerte oder Randbedingungen erfolgt. Es kann daher vorteilhaft sein, daß erst an letzter Stelle der vorzunehmenden Änderungen, d.h. erst dann, wenn die ersten beiden Änderungsarten keine eindeutige Lösung ergeben haben, beispielsweise die Randbedingungen für die Funktionalität der elektronischen Schaltung geändert werden. Dies bedeutet, daß unter Umständen auch die Funktionalität der Baugruppe geändert wird, daß also beispielsweise der mögliche Temperatureinsatzbereich einer Baugruppe geändert werden muß.

Besonders vorteilhaft bei der vorliegenden Erfindung ist es, daß vor und/oder während der Berechnung der Gleichungen durch den Computer die Randbedingungen und/oder die Startwerte zur Berechnung der Dimensionierung der Bauteile festgelegt werden können. Insbesondere dadurch, daß während der Berechnung der Gleichungen durch eine Änderung der Startwerte es ermöglicht wird, daß das komplexe Gleichungssystem in der Folge einfacher wird, ist eine schnelle, zuverlässige und insbesondere für den gewünschten Bereich richtige Dimensionierung der Bauteile mittels eines Computers möglich.

Als Randbedingungen werden Werte der Funktionalität der Baugruppe bzw. der Schaltung, wie beispielsweise zulässige Spannungsbereiche X₁ bis X₂ Volt, zulässige Stromstärken Y₁ bis Y₂ Watt oder ähnliches verstanden. Diese Werte der Funktionalität werden vor und/oder während der Berechnung der Gleichungen vorgegeben und/oder geändert. Dadurch ist es in vorteilhafter Weise möglich, daß die Gleichungssysteme zur Dimensionierung der Bauteile innerhalb der Baugruppen eine eindeutige Lösung ergeben. Insbesondere dadurch, daß während der Berechnung der Gleichungen die Werte der Funktionalität bei Bedarf geändert werden können, ist eine Lösung des Gleichungssystems zu erwarten.

Als Startwerte für die Berechnung werden Werte innerhalb der Randbedingungen gewählt. Diese Werte sind beispielsweise X Volt oder Y Watt, welche zwischen X₁ bis X₂ Volt bzw. Y₁ bis Y₂ Watt liegen. Diese Startwerte werden vor und/oder während der Berechnung der Gleichungen vorgegeben und/oder geändert. Insbesondere dann, wenn das Gleichungssystem keine eindeutige Lösung erhalten kann, werden die Startwerte innerhalb der Randbedingungen verändert, wodurch das Gleichungssystem nunmehr für die geforderte Funktionalität der Baugruppe lösbar sein kann. Ist auch mit diesen Startwerten eine eindeutige Lösung nicht zu erhalten, so kann der Startwert zum wiederholten Male geändert werden, so lange bis eine eindeutige Lösung erhalten wird oder bis festgestellt wird, daß unabhängig von den gewählten Startwerten eine eindeutige Lösung nicht zu erhalten ist. In diesem Falle sind die Randbedingungen oder die Bereiche der Funktionalität ebenfalls zu ändern.

Vorteilhaft ist es, wenn an dem Computer angezeigt wird, daß widersprüchliche oder unbestimmte Lösungsmöglichkeiten vorliegen. Es kann sodann entschieden werden, welche Maßnahmen zu ergreifen sind, um eine Lösung des Gleichungssystems für die gewünschte Dimensionierung der Bauteile zu erhalten.

Insbesondere bei widersprüchlichen Lösungsmöglichkeiten kann mittels einer manuellen Eingabe in das System die Auswahl der relevanten Lösungsmöglichkeiten bewirkt werden. Gleiches gilt auch für die Auswahl der Startwerte und Randbedingungen sowie der relevanten Bereiche der Funktionalitäten.

Ebenso wie bei widersprüchlichen oder unbestimmten Lösungsmöglichkeiten des Gleichungssystems ist es auch vorteilhaft, daß bei unbefriedigenden oder unvollständigen Dimensionierungen der Bauteile die Berechnung mit neuen Startwerten und/oder Randbedingungen erneut durchgeführt wird. Dies kann beispielsweise dann erforderlich sein, wenn durch das System errechnet wird, daß bestimmte Bauteile für die Baugruppe Verwendung finden sollten, welche aber beispielsweise aus Kostengründen für den Einsatz in der Baugruppe nicht zur Verfügung stehen.

Werden dem Computer konkrete, zu ändernde Startwerte und/oder Randbedingungen eingegeben, so wird in vorteilhafter Weise die automatische Suche des Computers verkürzt und die Lösung bzw. der Vorschlag einer konkreten Dimensionierung der Bauteile schneller erhalten.

Besonders vorteilhaft ist es, wenn vom Computer selbständig Startwerte oder evtl. auch Randbedingungen für eine insbesondere erneute Berechnung der Dimensionierung der Bauteile vorgeschlagen oder gewählt werden. Insbesondere dann, wenn der Computer selbständig die Berechnungen durchführt, ist es vorteilhaft, wenn die Startwerte oder Randbedingungen automatisch gewählt werden.

In einer halbautomatischen Lösung ist es besonders vorteilhaft, wenn der Computer bestimmte Startwerte oder Randbedingungen, welche geändert werden sollten, vorschlägt. Dies ist insbesondere dann von Vorteil, wenn durch den Computer angezeigt werden kann, welche Startwerte oder Randbedingungen bei der Berechnung der Dimensionierung der Bauteile zu schwierigen Gleichungen oder widersprüchlichen oder unbestimmten Lösungen führen und deshalb verändert werden sollten. Es kann dabei auch hilfreich sein, daß vom Computer angegeben wird, ob der zuvor gewählte Startwert oder die zuvor gewählte Randbedingungen vergrößert oder verkleinert werden sollte.

Ein besonders leistungsfähiges und damit vorteilhaftes Verfahren wird dadurch erzielt, daß mittels der geänderten Startwerte und/oder Randbedingungen eine Lösungsstrategie ermittelt wird, die bei anderen, ähnlichen Problemstellungen als erste Lösungsstrategie, welche untersucht wird, herangezogen wird. Damit können die Bauteile in weiteren Baugruppen, insbesondere weiteren elektronischen Schaltungen dimensioniert werden. Das System ermittelt somit, daß ein ähnliches oder gleiches Problem bereits bei früheren Dimensionierungen von Bauteilen in anderen Baugruppen vorgekommen ist und vergleicht die damals vorgenommene Änderung der Startwerte oder Randbedingungen mit der nunmehr vorliegenden Situation. Wenn festgestellt wird, daß tatsächlich eine ähnliche Situation vorliegt, wird als erste Lösungsstrategie in dem neuen Problem die zum Erfolg geführte Lösungsstrategie des damaligen Problems herangezogen oder vorgeschlagen. Es ist somit schneller möglich eine erfolgreiche Dimensionierung der Bauteile durchzuführen, da Fehler in der Änderung der Startwerte oder Randbedingungen bei dem damaligen Problem nicht erneut begangen werden.

Als besonders vorteilhaft im Hinblick auf eine geringe Notwendigkeit der Änderung von Startwerten oder Randbedingungen hat es sich herausgestellt, daß zuerst die einfachen Gleichungen und erst anschließend die komplizierteren Gleichungen gelöst werden. Durch die Lösung der einfachen Gleichungen ergeben sich unter Umständen Werte, welche durch das Einsetzen in den komplizierteren Gleichungen schnell zu weiteren Lösungen führen, da hierdurch die komplizierteren Gleichungen vereinfacht wurden. Das System wird somit noch leistungsfähiger und bedarf in vorteilhafter Weise nur geringe oder sogar keine Änderung der Startwerte oder Randbedingungen. Als besonders einfach hat sich die Berechnung der Gleichungen erwiesen, wenn die Gleichungen vor ihrer Berechnung nach dem voraussichtlichen Schwierigkeitsgrad ihrer Berechnung sortiert werden. Damit ist eine einfachere Abarbeitung der Gleichungen in den Gleichungssystemen möglich.

Das erfindungsgemäße Verfahren erlaubt es, geeignete Startwerte für die inneren Zustände des Lösungsmechanismus zu finden und diese zu setzen. Damit kann eine Lösungsstrategie erzeugt werden, die jederzeit wieder für die Lösung einer ähnlichen Problemstellung herangezogen werden kann. Bei einer solchen Wiederverwendung einer Lösungsstrategie resultiert ein erheblicher Zeitgewinn bei der Dimensionierung der Bauteile einer Baugruppe. Besonders vorteilhaft bei der vorliegenden Erfindung ist es, daß ein geeignetes Einschränken des Lösungsraums, was gleichbedeutend mit der Findung der Startwerte ist, stattfindet. Dies erfolgt entweder durch den Computer alleine oder auch im Dialog zwischen Computer und Benutzer. Der beschriebene Lösungsprozess wird so lange wiederholt, bis eine brauchbare technische Realisierung der gewünschten Baugruppe gefunden wurde.

## Patentansprüche

1. Verfahren zur Dimensionierung von Bauteilen in einer vorgegebenen Baugruppe, insbesondere einer elektronischen Schaltung, welche eine vorbestimmte, insbesondere in Randbedingungen festgelegte Funktionalität zu erfüllen hat, wobei die einzelnen Bauteile Eigenschaften aufweisen, die im wesentlichen vorbestimmt und in mathematischen Gleichungen beschrieben sind und die Bauteile auf Grund ihres Einsatzes in der vorgegebenen Baugruppe bzw. elektronischen Schaltung Wechselwirkungen erzeugen, dadurch gekennzeichnet, daß die durch die Gleichungen beschriebenen Eigenschaften und/oder Wechselwirkungen mittels eines Computers gelöst werden, wobei die erhaltenen Ergebnisse der ersten gelösten Gleichungen zu den erforderlichen Bauteilen bei der Lösung der weiteren Gleichungen herangezogen werden, und daß auf die Lösung und Weiterbearbeitung derjenigen Bereiche der Lösungsmöglichkeiten, die für die Dimensionierung der Bauteile in dieser vorgegebenen elektronischen Schaltung ohne praktische Relevanz sind, verzichtet wird.

2. Verfahren nach Anspruch 1, dadurch gekennzeichnet, daß die Bereiche der Lösungsmöglichkeiten, die entsprechend der vorbestimmten Funktionalität der vorgegebenen Baugruppe, insbesondere der elektronischen Schaltung von Bedeutung sind, vorgegeben werden.

3. Verfahren nach einem oder mehreren der vorangehenden Ansprüche, dadurch gekennzeichnet, daß im Falle widersprüchlicher oder unbestimmter Lösungsmöglichkeiten für die Dimensionierung der Bauteile anhand der vorgegebenen Funktionalität der Baugruppe, insbesondere der elektronischen Schaltung die Bereiche der Lösungsmöglichkeiten für Funktionalitäten ohne praktischer Relevanz in dieser Baugruppe, insbesondere Schaltung ausgeschlossen werden.

4. Verfahren nach einem oder mehreren der vorangehenden Ansprüche, dadurch gekennzeichnet, daß bei widersprüchlichen oder unbestimmten Lösungsmöglichkeiten entweder Bereiche hinsichtlich ihrer Relevanz eingeschränkt werden oder Startwerte der Berechnung geändert werden oder Randbedingungen der Funktionalität der Baugruppe, insbesondere elektronischen Schaltung geändert werden.

5. Verfahren nach einem oder mehreren der vorangehenden Ansprüche, dadurch gekennzeichnet, daß vor und/oder während der Berechnung der Gleichungen durch den Computer die Randbedingungen und/oder Startwerte zur Berechnung der Dimensionierung der Bauteile festgelegt werden

6. Verfahren nach einem oder mehreren der vorangehenden Ansprüche, dadurch gekennzeichnet, daß als Randbedingungen Werte der Funktionalität der Baugruppe, insbesondere der Schaltung, wie beispielsweise zulässige Spannungsbereiche x₁ - x₂ Volt, zulässige Stromstärken y₁ - y₂ Watt oder ähnliches vor und/oder während der Berechnung der Gleichungen vorgegeben und/oder geändert werden.

7. Verfahren nach einem oder mehreren der vorangehenden Ansprüche, dadurch gekennzeichnet, daß als Startwerte für die Berechnung Werte innerhalb der Randbedingungen, wie beispielsweise x Volt oder y Watt vor und/oder während der Berechnung der Gleichungen vorgegeben und/oder geändert werden.

8. Verfahren nach einem oder mehreren der vorangehenden Ansprüche, dadurch gekennzeichnet, daß an dem Computer angezeigt wird, daß widersprüchliche oder unbestimmte Lösungsmöglichkeiten vorliegen.

9. Verfahren nach einem oder mehreren der vorangehenden Ansprüche, dadurch gekennzeichnet, daß die Auswahl relevanter Bereiche der Lösungsmöglichkeiten mittels einer manuellen Eingabe in das System erfolgt.

10. Verfahren nach einem oder mehreren der vorangehenden Ansprüche, dadurch gekennzeichnet, daß bei einer unbefriedigenden oder unvollständigen Dimensionierung der Bauteile die Berechnung mit neuen Startwerten und/oder Randbedingungen erneut durchgeführt wird.

11. Verfahren nach einem oder mehreren der vorangehenden Ansprüche, dadurch gekennzeichnet, daß dem Computer konkrete, zu ändernde Startwerte und/oder Randbedingungen eingegeben werden.

12. Verfahren nach einem oder mehreren der vorangehenden Ansprüche, dadurch gekennzeichnet, daß vom Computer selbständig Startwerte und/oder Randbedingungen für eine insbesondere erneute Berechnung der Dimensionierung der Bauteile vorgeschlagen und/oder gewählt werden.

13. Verfahren nach einem oder mehreren der vorangehenden Ansprüche, dadurch gekennzeichnet, daß mittels der geänderten Startwerte und/oder Randbedingungen eine Lösungsstrategie ermittelt wird, die bei anderen, ähnlichen Problemstellungen als erste Lösungsstrategie herangezogen wird zur Dimensionierung der Bauteile in weiteren Baugruppen, insbesondere elektronischen Schaltungen.

14. Verfahren nach einem oder mehreren der vorangehenden Ansprüche, dadurch gekennzeichnet, daß zuerst die einfachen Gleichungen und erst anschließend die komplizierteren Gleichungen gelöst werden.

15. Verfahren nach einem oder mehreren der vorangehenden Ansprüche, dadurch gekennzeichnet, daß die Gleichungen vor ihrer Berechnung nach dem Schwierigkeitsgrad ihrer Berechnung sortiert werden.
